# EUROPÄISCHE PATENTSCHRIFT

(11) **EP 0 484 704 B1**
(45) Veröffentlichungstag und Bekanntmachung des Hinweises auf die Patenterteilung: **20.07.1994**
(21) Anmeldenummer: 91117606.3
(22) Anmeldetag: 16.10.1991
(51) Int. Cl.: C23C 14/30, H01J 37/305, H05B 7/18

(54) **Substratheizen mit Niedervoltbogenentladung und variablem Magnetfeld**
Low voltage arc discharge and variable magnetic field for heating a substrate
Echauffement de substrat par décharge en arc à basse tension et champ magnétique variable

(30) Priorität: 05.11.1990 DE 4035131
(43) Veröffentlichungstag der Anmeldung: 13.05.1992
(73) Patentinhaber: BALZERS AKTIENGESELLSCHAFT, 9496 Balzers (LI)
(72) Erfinder: Kaufmann, Helmut, Dr., L-9495 Triesen (LI); Schmid, Roland, Dr., A-6811 Göfis (AT)
(74) Vertreter: Troesch Scheidegger Werner AG

(56) Entgegenhaltungen:
- CH-A- 645 137
- CH-A- 658 545
- US-A- 4 197 175

## Beschreibung

Die vorliegende Erfindung betrifft ein Verfahren zum Erwärmen von Heizgut in einem Vakuumrezipienten. Solche Verfahren werden z.B. zum Entgasen, Löten, Sintern, Harten und in Verbindung mit Beschichtungs- oder Ionenbehandlungsverfahren verwendet. Dabei soll eine möglichst gleichmässige Erwärmung des Heizgutes erzielt werden. In bekannten Vakuum-Wärmebehandlungsöfen wird das Heizgut, z.B. mit Heizflächen umgeben, deren Wärme durch Strahlung oder Wärmeleitung auf das Heizgut übertragen wird. Elektrisch leitendes Heizgut kann auch durch induzierte Ströme erhitzt werden, und bekannt ist ferner die Verwendung einer Glimmentladung als Wärmequelle, die im Falle der sogenannten anomalen Entladung die gesamte Kathodenfläche gleichmässig bedeckt, so dass das als Kathode geschaltete Heizgut gleichmässig erwärmt werden kann.

Es ist weiter bekannt, Heizgut, z.B. zu schmelzende Metalle in Vakuum durch Elektronenbeschuss zu erhitzen. Dabei muss aber durch eine besondere geometrische Anordnung der Elektronenquelle dafür gesorgt werden, dass sich die gewünschte Temperaturverteilung auf dem Heizgut ergibt. Bisher war es nur mit entsprechend hohem Aufwand möglich, eine gleichmässige Erwärmung zu erzielen. Normalerweise aber wird der Elektronenbeschuss gerade in entgegengesetztem Sinn eingesetzt, nämlich zur Erzeugung lokal eng begrenzter heisser Stellen mit grossen Temperaturunterschieden zur Umgebung, wozu sich Elektronenstrahlen wegen ihrer leichten Fokussierbarkeit besonders eignen.

Eine spezielle Form der Heizung durch Elektronenbeschuss stellt die Beheizung mittels eines Niedervoltbogens dar; unter einem Niedervoltbogen im Rahmen dieser Beschreibung ist eine Gasentladung zu verstehen, welche zwischen einer heissen, durch Glühemission Elektronen emittierenden Kathode einerseits und einer Anode andererseits brennt (es ist in diesem Zusammenhang unerheblich, ob die Kathode allein durch die Gasentladung auf Emissionstemperatur gehalten wird oder zusätzlich geheizt wird). Meistens wird in der Nähe der Kathode ein Edelgas eingelassen, z.B. in den Hohlraum einer Hohlkathode oder in eine besondere Glühkathodenkammer, welche über eine Oeffnung mit dem Vakuumrezipienten verbunden ist. Es ist üblich, das aus der Hohlkathode oder aus der Glühkathodenkammer durch die Oeffnung in den Rezipienten eintretende Plasma mit Hilfe eines Magnetfeldes zu bündeln. Die Elektronen bewegen sich dabei auf engen Schraubenbahnen, deren Mittellinien weitgehend den Feldlinien des Magnetfeldes entsprechen. Anordnungen dieser Art sind, z.B. aus den US-A-3 210 454 und 4 197 175 bekannt. Beide beschreiben das Erhitzen eines Schmelzgutes, welches als Anode geschaltet ist, mittels eines magnetisch gebündelten Niedervoltbogens, der auf das Schmelzgut gerichtet ist (zielt). Letzteres wird dadurch erreicht, dass die magnetischen Feldlinien - und damit auch die gewendelten Elektronenbahnen - durch die erwähnte Oeffnung und durch das Schmelzgut laufen. Der Niedervoltbogen wird also hierbei zur Erzeugung lokal begrenzter heisser Stellen mit grossen Temperaturunterschieden zur Umgebung verwendet. Elektronenstrahlöfen oder Lichtbogenöfen für die Wärmebehandlung von Heizgut zu benutzen, dessen Oberfläche gleichmässig erwärmt werden sollte, erschien, wie gesagt, schwierig, denn eine ausreichend gleichförmige Stromdichteverteilung auf dem Heizgut konnte man kaum erreichen.

Gemäss der CH-A-658 545 wird weiter ein Verfahren zum gleichmässigen Erwärmen von Heizgut in einem Vakuumrezipienten durch Aufrechterhalten einer magnetisch gebündelten Niedervoltbogenentladung vorgeschlagen. Dabei wird das Magnetfeld derart aufrechterhalten, dass die Magnetfeldlinien im wesentlichen parallel zu den Oberflächen des Heizgutes verlaufen. Insbesondere bei längsausgedehnten Substrat- resp. Substratrezipienten hat sich aber auch dieses Verfahren als nicht einwandfrei erwiesen, da in der sogenannten Bauchmitte des Magnetfeldes das Substrat stärker erwärmt wird, als in den Randbereichen des Magnetfeldes, was zu einem Härteverlust des Grundmaterials führt.

In der DE-A- 38 29 260 wird schlussendlich vorgeschlagen, dass zwischen die Kathode und den zu beschichtenden Gegenstand während der Aufwärmphase ein Schirm angeordnet wird, der nach Erreichen der Prozesstemperatur entfernt wird. Damit ist aber das Problem des gleichmässigen Erwärmens wieder nicht gelöst.

Es ist daher eine Aufgabe der vorliegenden Erfindung ein Verfahren zum gleichmässigen Erwärmen eines Heizgutes resp. Substrates vorzuschlagen, mittels welchem auch beispielsweise längsausgedehnte Substrate, resp. längsausgedehnte Substrathalterungen mit mehreren Substraten gleichmässig aufgeheizt werden.

Erfindungsgemäss wird diese Aufgabe mittels einem Verfahren gemäss dem Wortlaut nach Anspruch 1 gelöst.

Gemäss dem erfindungsgemässen Verfahren wird in der Heizkammer, in welchem das Heizgut resp. das zu beschichtende Substrat mittels einer Gasentladung resp. einer Niedervoltbogenentladung erwärmt wird, wobei die Gasentladung resp. die Niedervoltbogenentladung magnetisch gebündelt wird, und wobei wenigstens während dem Heizen mindestens ein örtlich variables und/oder verschiebbares Magnetfeld aufrechterhalten wird. Dabei ist es entweder möglich, das Magnetfeld stationär zu halten und durch die Stromstärke in der Magnetspule zu variieren, oder aber die Magnetspule örtlich zu verschieben, womit auch das damit verbundene Magnetfeld örtlich verschoben wird. Wesentlich dabei ist, dass die Verteilung der Stromdichte in der Vakuumkammer beeinflusst wird, um so die Elektronen in der Gasentladung in verschiedene Bereich der Vakuumkammer zu verschieben, und um so ein gleichmässiges Erwärmen der Substratoberfläche resp. der Oberfläche des Heizgutes zu bewerkstelligen. Eine grössere Elektronendichte führt örtlich zu einer stärkeren Erwärmung des entsprechenden Substratbereiches. Durch das Hin- und Herdrängen der Elektronen durch die Variation des Magnetfeldes kann so ein gleichmässiges Erwärmen des Substrates erreicht werden.

Gemäss einer bevorzugten Ausführungsvariante werden mindestens zwei sich teilweise überlappende Magnetfelder aufrechterhalten, die wechselweise stärker und schwächer betrieben werden. Auf diese Art und Weise kann entlang der Substratoberfläche wechselweise stärkere oder schwächere Erwärmung bewirkt werden. Die Elektronen werden dabei immer in denjenigen Bereich gedrängt, wo das Magnetfeld schwächer ist. Entsprechend ist die Erwärmung des Substrates in demjenigen Bereich grösser, wo das Magnetfeld schwächer aufrechterhalten wird.

Vorzugsweise wird das mindestens eine oder die beiden erwähnten Magnetfelder parallel entlang der Oberfläche des Heizgutes, resp. des Substrates örtlich variiert und/oder verschiebbar aufrechterhalten.

Selbstverständlich ist es auch möglich, gleichzeitig das Heizgut resp. das zu beschichtende Substrat im Magnetfeld örtlich zu verschieben.

Weitere bevorzugte Ausführungen des erfindungsgemässen Verfahrens ergeben sich aus dem Wortlaut nach einem der Ansprüche 5 - 8.

Für die Durchführung des Verfahrens wird weiter eine Vorrichtung für das gleichmässige Erwärmen von Heizgut resp. eines zu beschichtenden Substrates vorgeschlagen, welche eine Vakuumkammer für die Aufnahme des Heizgutes oder Substrates umfasst, sowie eine mit der Vakuumkammer in Verbindung stehenden Kathodenkammer mit einer darin befindlichen heissen Kathode, sowie mit mindestens einer im Bereich der Vakuumkammer angeordneten Magnetspule, welche derart betreibbar ist, dass in der Vakuumkammer wenigstens während dem Heizen ein örtlich variables und/oder verschiebbares Magnetfeld aufrechterhalten werden kann.

Vorzugsweise werden im Bereich der Vakuumkammer mindestens zwei Magnetspulen vorgesehen, die derart voneinander beabstandet angeordnet sind, dass in der Vakuumkammer zwei im wesentlichen zum Heizgut resp. zu den Substraten koaxiale Magnetfelder entstehen.

Die Erfindung wird nun anschliessend anhand von Beispielen und unter Bezug auf die beigefügten Figuren näher erläutert. Dabei zeigen:
- Fig. 1: eine erfindungsgemässe Aufheiz- resp. Beschichtungskammer mit zwei Magnetspulen,
- Fig. 2: in Diagrammform den Betrieb der beiden Magnetspulen, und
- Fig. 3 und 4: in Diagrammform die Temperaturverteilungen in der Vakuumkammer resp. Beschichtungsanlage mit unterschiedlichen Magnetfeldern und mit einem gleichmässigen Magnetfeld.

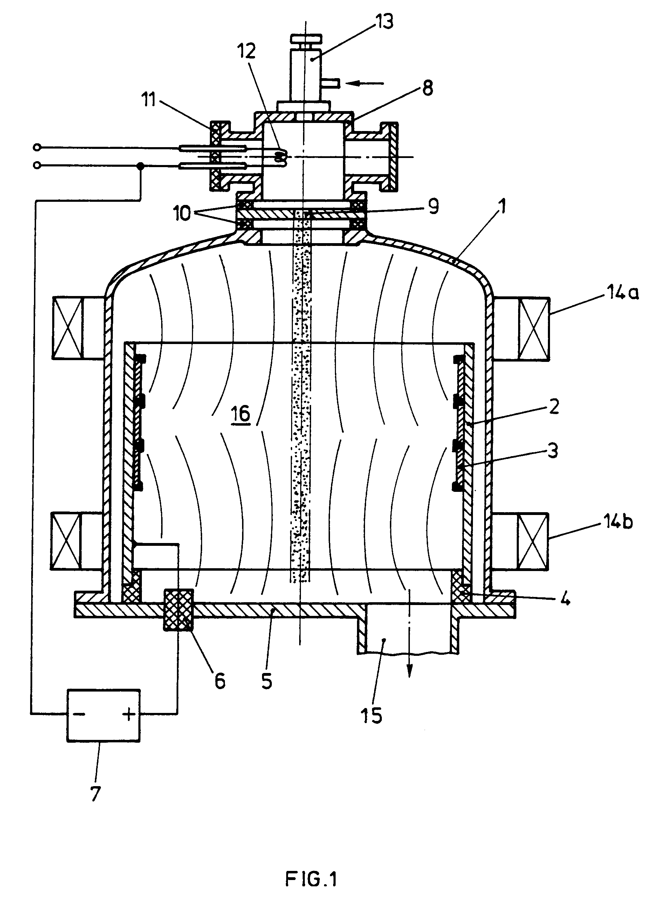

In Fig. 1 bedeutet 1 einen glockenförmigen Vakuumrezipienten, in dem auf einer Halterung 2 das Heizgut 3 getragen ist. Die Halterung ist mittels einer elektrischen Isolation 4 an der Bodenplatte 5 des Rezipienten befestigt und wird über eine vakuumdichte Stromdurchführung 6 mit dem positiven Pol eines Speisegerätes 7 elektrisch verbunden. Am oberen Teil des Rezipienten ist eine Glühkathodenkammer 8 angebracht und über eine Oeffnung 9 mit dem Innenraum des Rezipienten 1 verbunden. In dieser Glühkathodenkammer ist, von einer isolierenden Platte 11 getragen, die Glühkathode 12 untergebracht, die, wie in der Zeichnung angedeutet, ein durch Stromdurchgang geheizter Draht sein kann; sie kann aber auch in Form einer geheizten oder sich selbst aufheizenden Hohlkathode ausgebildet werden. Für das Einlassen von Gasen in die Glühkathodenkammer ist ein Regelventil 13 vorgesehen.

Zwei Magnetspulen 14a und 14b erzeugen zum Rezipienten 1 koaxiale Magnetfelder 16. Folgt man der zentralen Feldlinie, ausgehend von der Oeffnung 9, so wird das Magnetfeld 16 zunächst stärker und erreicht eine maximale Intensität auf der Mittelebene der Magnetspule 14a. Beim weiteren Entfernen von der Oeffnung 9 schwächt sich das Magnetfeld zunächst ab, wird anschliessend wieder stärker und erreicht ein zweites Maximum der Intensität auf der Mittelebene der Magnetspule 14b. Die Stärke der Magnetfelder 16 ist nun davon abhängig, mit welcher Stromstärke die beiden Magnetspulen 14a resp. 14b betrieben werden. In der in Fig. 1 dargestellten Vorrichtung ist vorgesehen, dass die beiden Magnetspulen 14a und 14b mit unterschiedlichen Stromstärken betreibbar sind.

Um den Heizprozess durchzuführen, pumpt man mit Hilfe einer Hochvakuumpumpe am Pumpenstutzen 15 den Rezipienten und die mit ihm verbundene Glühkathodenkammer 8 luftleer, bis ein Druck kleiner als etwa 0,01 P erreicht ist. Bei laufender Pumpe lässt man dann durch das Ventil 13 soviel Gas, z.B. das Edelgas Argon, einströmen, dass sich im Rezipienten ein Argondruck zwischen 0,1 und 1 P einstellt. Man heizt dann die Glühkathode 12 und schaltet das Speisegerät 7 ein. Letzteres erzeugt eine elektrische Spannung von z.B. 100 V. Die durch die Oeffnung 9 in den Rezipienten 1 eintretenden Elektronen folgen, bei ausreichenden Feldstärken, (z.B. 0,01 T) den Feldlinien der Magnetfelder. Die Magnetfelder bewirken, dass sich die Elektronen parallel zur Achse leichter bewegen können, als senkrecht zur Achse. Dadurch wird der Elektronenstrom auf dem Ganzen, als Anode geschalteten Halter 2, verteilt.

Im Gegensatz zur entsprechenden Vorrichtung gemäss der CH-PS 658 545, wo nur eine Spule angeordnet ist, ergibt sich bei Anordnen zweier Spulen bereits eine wesentliche Verbesserung in bezug auf gleichmässigere Erwärmung entlang des Heizgutes. Trotzdem aber bestehen bei gleicher Magnetfeldstärke der beiden Magnetspulen 14a und 14b gewisse Temperaturmaxima am Heizgut auf den Mittelebenen durch die Magnetspule 14a resp. Magnetspule 14b. Aus diesem Grund ist es vorteilhaft, die beiden Magnetspulen 14a und 14b durch unterschiedliche Spulenströme zu betreiben, damit unterschiedliche Magnetfelder entstehen. Durch die Variation der Magnetfelder kann die Verteilung der Stromdichte in vertikaler Richtung, bezogen auf die Darstellung in Fig. 1, beeinflusst werden. Ein stärkeres Magnetfeld in der oberen Spule drängt die Elektronen in der Gasentladung in den unteren Substratbereich und führt hier zu einer stärkeren Erwärmung. Bei einer Vergrösserung des unteren Magnetfeldes wird der obere Substratbereich mehr erwärmt.

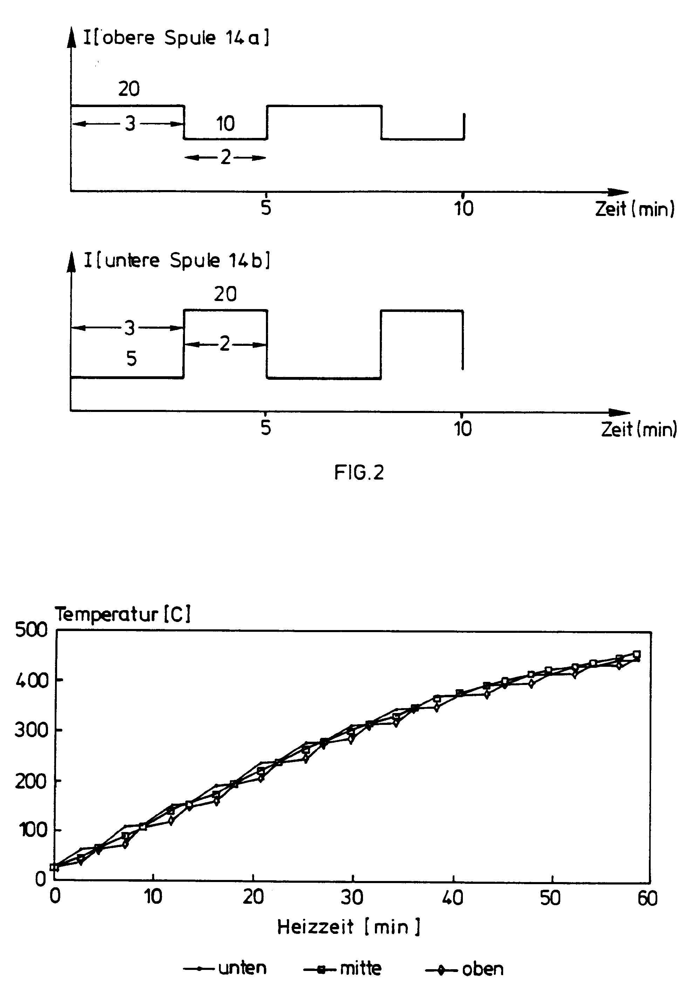

In Fig. 2 ist nun in Diagrammform dargestellt, wie die beiden Magnetspulen 14a und 14b beispielsweise zu betreiben sind. Das obere Diagramm in Fig. 2 bezieht sich auf die Stromstärke in der oberen Spule, währenddem das untere Diagramm die Stromstärke in der unteren Spule 14b betrifft.

Gemäss Fig. 2 wird bei Beginn der Aufwärmphase zunächst die obere Magnetspule während den ersten 3 Minuten durch eine stärkere Stromstärke I durchflossen als die untere Spule. Während den darauf folgenden weiteren 2 Minuten ist die Stromstärke invers, d.h. das untere Magnetfeld ist stärker als das obere Magnetfeld. Wie oben angeführt, werden durch die unterschiedlichen Magnetfelder die Elektronen in der Gasentladung hin und her gedrängt, so dass auf diese Art und Weise das Substrat, resp. das Heizgut 3 über seine gesamte Oberfläche gleichmässig erwärmt wird.

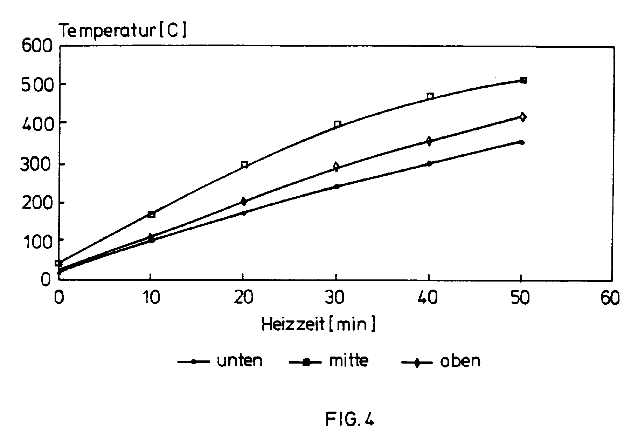

In Fig. 3 und Fig. 4 ist graphisch der Einfluss dargestellt, wenn die Magnetfelder unterschiedlich betrieben werden. Dabei zeigt sich deutlich, dass bei gleichmässigem Magnetfeld gemäss Fig 4 der untere und obere Bereich der Beschichtungsanlage resp. im Rezipienten schwächer erwärmt wird, als der mittlere Bereich. Bei unterschiedlich betriebenen Magnetfeldern gemäss Fig 3 ist die Erwärmung gleichmässig und entspricht inetwa dem Mittelwert der Erwärmung beim Betreiben des Magnetfeldes ohne Variation. Durch das Diagramm in Fig. 4 wird deutlich, dass nicht nur das Vorhandensein zweier Magnetfelder allein für eine gleichmässige Erwärmung des Heizgutes verantwortlich ist, sondern auch wie in Fig. 3 dargestellt durch das unterschiedliche Betreiben der Magnetfelder, wie beispielsweise unter Bezug auf Fig. 2 beschrieben.

Die in Fig. 1 dargestellte Vorrichtung umfasst selbstverständlich nur eine beispielsweise Ausführung. So ist es beispielsweise auch möglich, nur eine Magnetspule anzuordnen, welche aber örtlich verschoben werden kann. Auch ist es möglich mehrere Magnetspulen anzuordnen, wobei beispielsweise zusätzlich eine Magnetspule im Bereich der Glühkathodenkammer 8 angeordnet werden kann. Bei Anordnen einer Magnetspule im Bereich der Glühkathodenkammer 8 ist es auch möglich, entlang des Rezipienten 1 nur eine Magnetspule 14 anzuordnen. Wiederum ist es möglich mittels unterschiedlicher Stromstärken I in den so angeordneten Magnetspulen unterschiedliche Magnetfelder im Rezipienten zu erzeugen. Selbstverständlich ist es auch möglich die Glühkathodenkammer durch eine Funkenkammer, ähnlich derjenigen in der DE-A- 38 29 260 beschrieben, zu ersetzen.

Erfindungswesentlich ist in jedem Fall nur, dass in der Beschichtungskammer resp. im Rezipienten oder der Vakuumkammer mindestens ein variierbares Magnetfeld erzeugt wird, um so die Stromdichte während dem Aufheizvorgang in der Kammer örtlich zu verändern.

## Patentansprüche

1. Verfahren zum gleichmässigen Erwärmen von Heizgut resp. von zu beschichtenden Substraten in einer Vakuumkammer durch Beschuss des Heizgutes resp. der Substrate mittels einer Gasentladung resp. Niedervoltbogenentladung zwischen einer in einer nicht in Sichtkontakt zu den Substraten stehenden Elektronen erzeugenden Kathode und einer Anode an der Aufnahme für das Heizgut oder das Substrat, wobei die Gasentladung resp. Niedervoltbogenentladung in der Vakuumkammer magnetisch gebündelt aufrecht erhalten wird, dadurch gekennzeichnet, dass wenigstens während dem Heizen mindestens ein örtlich variables und/oder verschiebbares Magnetfeld aufrechterhalten wird, um die Verteilung der Stromdichte, resp. der Elektronendichte zu beeinflussen.

2. Verfahren, nach Anspruch 1, dadurch gekennzeichnet, dass mindestens zwei sich teilweise überlappende Magnetfelder aufrechterhalten werden, die wechselweise stärker und schwächer betrieben werden, um so entlang dem Heizgut resp. Substrat örtlich wechselweise stärkere oder schwächere Erwärmung zu erwirken.

3. Verfahren, nach mindestens einem der Ansprüche 1 oder 2, dadurch gekennzeichnet, dass das mindestens eine Magnetfeld parallel entlang der Oberfläche des Heizgutes resp. Substrates örtlich variiert und/oder verschiebbar aufrechterhalten wird.

4. Verfahren, nach mindestens einem der Ansprüche 1 - 3, dadurch gekennzeichnet, dass das Heizgut, resp. das zu beschichtende Substrat gleichzeitig bewegt wird.

5. Verfahren, nach mindestens einem der Ansprüche 1 - 4, dadurch gekennzeichnet, dass die Gasentladung resp. Niedervoltbogenentladung zwischen einer in einer Kathodenkammer befindlichen, heissen Kathode und einer Anode erfolgt.

6. Verfahren, nach mindestens einem der Ansprüche 1 - 5, dadurch gekennzeichnet, dass während des Heizens ein solches Magnetfeld aufrechterhalten wird, dass diejenigen Magnetfeldlinien, welche durch die Oeffnung zwischen der Kathodenkammer und der Aufnahme für das Heizgut resp. Substrat hindurchtreten, das Heizgut resp. Substrat nicht durchstossen.

7. Verfahren, nach mindestens einem der Ansprüche 1 - 6, dadurch gekennzeichnet, dass das Heizgut resp. Substrat selbst als Anode der Niedervoltbogenentladung geschaltet wird.

8. Verfahren, nach mindestens einem der Ansprüche 1 - 7, dadurch gekennzeichnet, dass im Bereich zu erhitzender Oberflächen des Heizgutes resp. Substrates ein zu diesen im wesentlichen paralleles Magnetfeld aufrechterhalten wird.

9. Verfahren, nach mindestens einem der Ansprüche 1 - 8, dadurch gekennzeichnet, dass das Heizgut resp. Substrat um das Plasmabündel herum angeordnet wird.

10. Vorrichtung zur Durchführung des Verfahrens nach einem der Ansprüche 1 - 9, mit einer Beschichtungskammer resp. Heizkammer zum gleichmässigen Erwärmen von Heizgut resp. von zu beschichtenden Substraten, sowie mit einer nicht in Sichtkontakt zu den Substraten resp. zum Heizgut stehenden Elektronen erzeugenden Kathode und einer Anode an der Aufnahme für das Heizgut oder das Substrat für die Erzeugung einer Gasentladung resp. eines Niedervoltbogens, dadurch gekennzeichnet, dass mindestens eine Einrichtung (14a, 14b) zur Erzeugung eines Magnetfeldes in der Heizkammer angeordnet ist, die derart betreibbar ist, dass örtlich ein variables Magnetfeld erzeugbar ist.

11. Vorrichtung zur Durchführung des Verfahrens nach einem der Ansprüche 1 - 9, mit einer evakuierbaren Heizkammer (1), einer darin befindlichen Aufnahme (2) für ein Heizgut resp. für ein Substrat (3) und mit einer, eine heisse Kathode (12) enthaltenden, über eine Oeffnung (9) für den Durchtritt des durch die Niedervoltbogenentladung erzeugten Plasmas mit der Heizkammer in Verbindung stehenden Kathodenkammer (8), dadurch gekennzeichnet, dass mindestens eine Einrichtung (14a, 14b) zur Erzeugung eines Magnetfeldes in der Heizkammer angeordnet ist, die derart betreibbar ist, dass örtlich ein variables Magnetfeld erzeugbar ist.

12. Vorrichtung, nach mindestens einem der Ansprüche 10 oder 11, dadurch gekennzeichnet, dass die Einrichtung zur Erzeugung des Magnetfeldes im wesentlichen parallel zur Aufnahme für das Heizgut resp. das zu beschichtende Substrat verschieblich angeordnet ist.

13. Vorrichtung, nach mindestens einem der Ansprüche 10 bis 12, dadurch gekennzeichnet, dass die Einrichtung zur Erzeugung des Magnetfeldes mindestens zwei voneinander beabstandete Magnetspulen (14a, 14b) zur Erzeugung der das Plasma bündelnden Magnetfelder umfasst, wobei die Magnetspulen derart angeordnet sind, dass die von ihnen erzeugten, magnetischen Feldlinien im wesentlichen parallel zur Aufnahme für das Heizgut, resp. des zu beschichtenden Substrates verlaufen.

14. Vorrichtung, nach mindestens einem der Ansprüche 10 - 13, dadurch gekennzeichnet, dass zwischen Kathode und dem Heizgut resp. Substrat ein Schirm angeordnet ist.

## Claims

1. A method of uniformly heating material to be heated or subtrates to be coated in a vacuum chamber by bombardment of the material to be heated or the substrates by means of a gas discharge or low voltage arc discharge between a cathode which produces electrons and is not in line-of-sight contact with the substrates, and an anode at the receiving means for the material to be heated or the substrate, wherein the gas discharge or low voltage arc discharge is maintained magnetically concentrated in the vacuum chamber, characterised in that at least during the heating operation at least one locally variable and/or displaceable magnetic field is maintained to influence the distribution of the current density or the electron density.

2. A method according to claim 1 characterised in that at least two partially overlapping magnetic fields are maintained, which are operated alternately more strongly and more weakly in order thereby to produce along the material to be heated or the substrate a heating effect which is locally alternately stronger or weaker.

3. A method according to at least one of claims 1 and 2 characterised in that the at least one magnetic field is maintained displaceably and/or locally varied in parallel relationship along the surface of the material to be heated or the substrate.

4. A method according to at least one of claims 1 to 3 characterised in that the material to be heated or the substrate to be coated is simultaneously moved.

5. A method according to at least one of claims 1 to 4 characterised in that the gas discharge or low voltage arc discharge takes place between a hot cathode disposed in a cathode chamber, and an anode.

6. A method according to at least one of claims 1 to 5 characterised in that during the heating operation such a magnetic field is maintained that those magnetic field lines which pass through the opening between the cathode chamber and the receiving means for the material to be heated or substrate do not penetrate the material to be heated or the substrate.

7. A method according to at least one of claims 1 to 6 characterised in that the material to be heated or the substrate is itself connected as the anode of the low voltage arc discharge.

8. A method according to at least one of claims 1 to 7 characterised in that a magnetic field which is substantially parallel to surfaces, which are to be heated, of the material to be heated or substrate, is maintained in the region of said surfaces.

9. A method according to at least one of claims 1 to 8 characterised in that the material to be heated or the substrate is arranged around the plasma stream.

10. Apparatus for carrying out the method according to one of claims 1 to 9 comprising a coating chamber or heating chamber for uniformly heating material to be heated or substrates to be coated, and a cathode which produces electrons and is not in line-of-sight contact with the substrates or the material to be heated, and an anode at the receiving means for the material to be heated or the substrate for the production of a gas discharge or a low voltage arc, characterised in that at least one means (14a, 14b) is arranged for generating a magnetic field in the heating chamber, which can be operated in such a way that a variable magnetic field can be locally generated.

11. Apparatus for carrying out the method according to one of claims 1 to 9 comprising an evacuatable heating chamber (1), a receiving means (2) disposed therein for a material to be heated or for a substrate (3), and a cathode chamber (8) which contains a hot cathode (12) and which is communicated with the heating chamber by way of an opening (9) for the passage of the plasma produced by the low voltage arc discharge, characterised in that at least one means (14a, 14b) is arranged for generating a magnetic field in the heating chamber, which can be operated in such a way that a variable magnetic field can be locally generated.

12. Apparatus according to at least one of claims 10 and 11 characterised in that the means for generating the magnetic field is arranged displaceably substantially parallel to the receiving means for the material to be heated or the substrate to be coated.

13. Apparatus according to at least one of claims 10 to 12 characterised in that the means for generating the magnetic field includes at least two spaced-apart magnetic coils (14a, 14b) for producing the magnetic fields for concentrating the plasma, the magnetic coils being arranged in such a way that the magnetic field lines generated thereby extend substantially parallel to the receiving means for the material to be heated or the substrate to be coated.

14. Apparatus according to at least one of claims 10 to 13 characterised in that a shield is arranged between the cathode and the material to be heated or the substrate.

## Revendications

1. Procédé pour chauffer de façon homogène un produit à chauffer ou des substrats à revêtir, dans une chambre sous vide, grâce au bombardement dudit produit ou des substrats à l'aide d'une décharge gazeuse ou d'une décharge en arc à basse tension entre une cathode qui génère des électrons qui ne sont pas en contact visuel avec les substrats, et une anode qui est située au niveau du logement prévu pour le produit à chauffer ou pour le substrat, la décharge gazeuse ou la décharge en arc à basse tension étant maintenue dans la chambre sous vide avec une focalisation magnétique, caractérisé en ce qu'on maintient, au moins pendant le chauffage, au moins un champ magnétique variable localement et/ou apte à être déplacé, afin d'influencer la répartition de la densité du courant ou des électrons.

2. Procédé selon la revendication 1, caractérisé en ce qu'on maintient au moins deux champs magnétiques se recouvrant partiellement qui sont alternativement plus forts et plus faibles afin de provoquer localement, le long du produit à chauffer ou du substrat, un échauffement alternativement plus fort ou plus faible.

3. Procédé selon l'une au moins des revendications 1 ou 2, caractérisé en ce qu'on maintient le ou les champs magnétiques en les faisant varier localement et/ou en les déplaçant parallèlement le long de la surface du produit à chauffer ou du substrat.

4. Procédé selon l'une au moins des revendications 1 à 3, caractérisé en ce qu'on déplace en même temps le produit à chauffer ou le substrat à revêtir.

5. Procédé selon l'une au moins des revendications 1 à 4, caractérisé en ce que la décharge gazeuse ou la décharge en arc à basse tension a lieu entre une cathode chaude située dans une chambre à cathode, et une anode.

6. Procédé selon l'une au moins des revendications 1 à 5, caractérisé en ce qu'on maintient pendant le chauffage un champ magnétique tel que les lignes de champ magnétique qui entrent par l'ouverture définie entre la chambre à cathode et le logement prévu pour le produit à chauffer ou le substrat ne traversent pas celui-ci.

7. Procédé selon l'une au moins des revendications 1 à 6, caractérisé en ce que le produit à chauffer ou le substrat lui-même est monté comme une anode de la décharge en arc à basse tension.

8. Procédé selon l'une au moins des revendications 1 à 7, caractérisé en ce qu'on maintient, dans la zone de surfaces à chauffer du produit ou du substrat, un champ magnétique sensiblement parallèle à celles-ci.

9. Procédé selon l'une au moins des revendications 1 à 8, caractérisé en ce que le produit à chauffer ou le substrat est disposé tout autour du faisceau de plasma.

10. Dispositif pour la mise en oeuvre du procédé selon l'une des revendications 1 à 9, comportant une chambre de revêtement ou une chambre de chauffage pour chauffer de façon homogène un produit à chauffer ou des substrats à revêtir, une cathode générant des électrons qui ne sont pas en contact visuel avec les substrats ou le produit à chauffer, et une anode située au niveau du logement prévu pour le produit à chauffer ou pour le substrat, pour la production d'une décharge gazeuse ou d'un arc à basse tension, caractérisé en ce qu'au moins un dispositif (14a, 14b) destiné à générer un champ magnétique est disposé dans la chambre de chauffage, lequel dispositif est apte à être actionné pour pouvoir générer localement un champ magnétique variable.

11. Dispositif pour la mise en oeuvre du procédé selon l'une des revendications 1 à 9, comportant une chambre de chauffage (1) dans laquelle on peut faire le vide, un logement (2) situé dans celle-ci et destiné à un produit à chauffer ou un substrat (3), et une chambre à cathode (8) contenant une cathode chaude (12) et communiquant avec la chambre de chauffage par l'intermédiaire d'une ouverture (9) prévue pour le passage du plasma produit par la décharge en arc à basse tension, caractérisé en ce qu'au moins un dispositif (14a, 14b) destiné à générer un champ magnétique est disposé dans la chambre de chauffage, lequel dispositif est apte à être actionné pour pouvoir générer localement un champ magnétique variable.

12. Dispositif selon l'une au moins des revendications 10 ou 11, caractérisé en ce que le dispositif prévu pour générer le champ magnétique est disposé pour être mobile sensiblement parallèlement au logement prévu pour le produit à chauffer ou pour le substrat à revêtir.

13. Dispositif selon l'une au moins des revendications 10 à 12, caractérisé en ce que le dispositif prévu pour générer le champ magnétique comprend au moins deux bobines magnétiques (14a, 14b) espacées l'une de l'autre et destinées à générer les champs magnétiques focalisant le plasma, les bobines magnétiques étant disposées de telle sorte que les lignes de champs magnétiques qu'elles génèrent sont sensiblement parallèles au logement prévu pour le produit à chauffer ou pour le substrat à revêtir.

14. Dispositif selon l'une au moins des revendications 10 à 13, caractérisé en ce qu'un écran est disposé entre la cathode et le produit à chauffer ou le substrat.
